# EUROPEAN PATENT APPLICATION

(11) **EP 4 485 743 A1**
(43) Date of publication of application: **01.01.2025**
(21) Application number: 23205782.8
(22) Date of filing: 25.10.2023
(51) Int. Cl.: H02J 7/00

(54) **ADAPTIVE BATTERY USAGE WINDOW TO EXTEND BATTERY LONGEVITY**

(30) Priority: 28.06.2023 US 202318215734
(71) Applicant: Intel Corporation, Santa Clara, CA 95054 (US)
(72) Inventor: Matsumura, Naoki, San Jose, 95118 (US)
(74) Representative: Goddar, Heinz J.

(57) **Abstract**

Methods and apparatus relating to an adaptive battery usage window to extend battery longevity are described. In an embodiment, a State Of Charge (SOC) for a rechargeable battery is controlled based on a plurality of limited charging modes that may selectively allow/prevent charging/discharging of the rechargeable battery to target level(s). Other embodiments are also disclosed and claimed.

## Description

### FIELD

The present disclosure generally relates to the field of battery technology. More particularly, some embodiments relate to adaptive battery usage window to extend battery longevity.

### BACKGROUND

Lithium-ion (Li-ion) batteries are commonly used for various mobile devices (such as laptops, smartphones, smart watches, etc.) as well as Electric Vehicles (EVs).

While such batteries may provide a relatively long battery-life or driving-range at the beginning of their life cycle, they tend to degrade over time, e.g., when charging/discharging are repeated and/or the batteries are stored at a high State-Of-Charge (SOC) for a relatively long period, resulting in shorter battery-life or driving-range over time. Hence, mitigating battery degradation has become a major goal.

### BRIEF DESCRIPTION OF THE DRAWINGS

The detailed description is provided with reference to the accompanying figures. In the figures, the left-most digit(s) of a reference number identifies the figure in which the reference number first appears. The use of the same reference numbers in different figures indicates similar or identical items.
FIG. 1 illustrates a block diagram of a device to provide an adaptive battery usage window, according to an embodiment.
FIG. 2 illustrates an example graph of a conventional limited charging approach compared to normal charging.
FIG. 3 illustrates a sample graph of degradation regions of next generation battery.
FIG. 4 illustrates a graph for an adaptive battery usage window to extend battery longevity, according to an embodiment.
FIG. 5 illustrates a flow diagram of a method to provide an adaptive battery usage window to extend battery longevity, according to an embodiment.
FIG. 6 illustrates an example computing system.

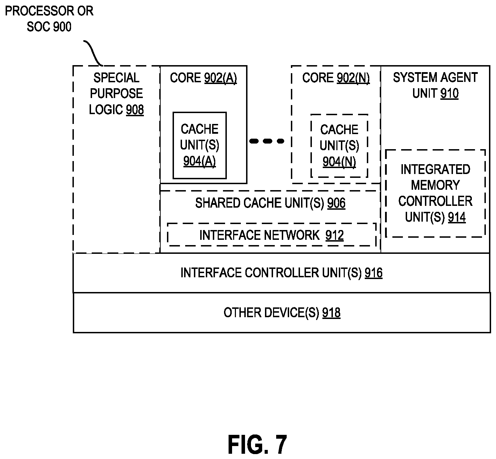

FIG. 7 illustrates a block diagram of an example processor and/or System on a Chip (SoC) that may have one or more cores and an integrated memory controller.

### DETAILED DESCRIPTION

In the following description, numerous specific details are set forth in order to provide a thorough understanding of various embodiments. However, various embodiments may be practiced without the specific details. In other instances, well-known methods, procedures, components, and circuits have not been described in detail so as not to obscure the particular embodiments. Further, various aspects of embodiments may be performed using various means, such as integrated semiconductor circuits ("hardware"), computer-readable instructions organized into one or more programs ("software"), or some combination of hardware and software. For the purposes of this disclosure reference to "logic" shall mean either hardware (such as logic circuitry or more generally circuitry or circuit), software, firmware, or some combination thereof.

As mentioned above, mitigating battery degradation has become a major goal for battery-operated devices. To address this, many of today's systems offer "limited charging," where a charging system manually or automatically identifies a target level of battery charging (e.g., 60% charge) and avoids charging fully or to 100%. When limited charging is set, a battery charge indicator such as a full charge battery-life or driving range is based on the limited charge level instead of the actually full charge/range. Moreover, while conventional limited charging may extend battery longevity by avoiding a high SOC region, the conventional limited charging works for an existing Li-ion battery but fails to offer an ideal solution for the next generation batteries that have a high level of degradation region in low SOC as well.

To this end, some embodiments provide an adaptive battery usage window to extend battery longevity. At least one embodiment considers battery degradation rate by SOC regions and adjusts the battery usage window in a limited charging mode to avoid high degradation regions including high SOC and low SOC regions. Since such embodiments avoid high degradation regions in both high SOC and low SOC regions, they are envisioned to offer a better longevity than the conventional limited charging that tends to only consider a high SOC degradation region. In an embodiment, a SOC for a rechargeable battery is controlled based on a plurality of limited charging modes that may selectively allow/prevent charging/discharging of the rechargeable battery to target level(s).

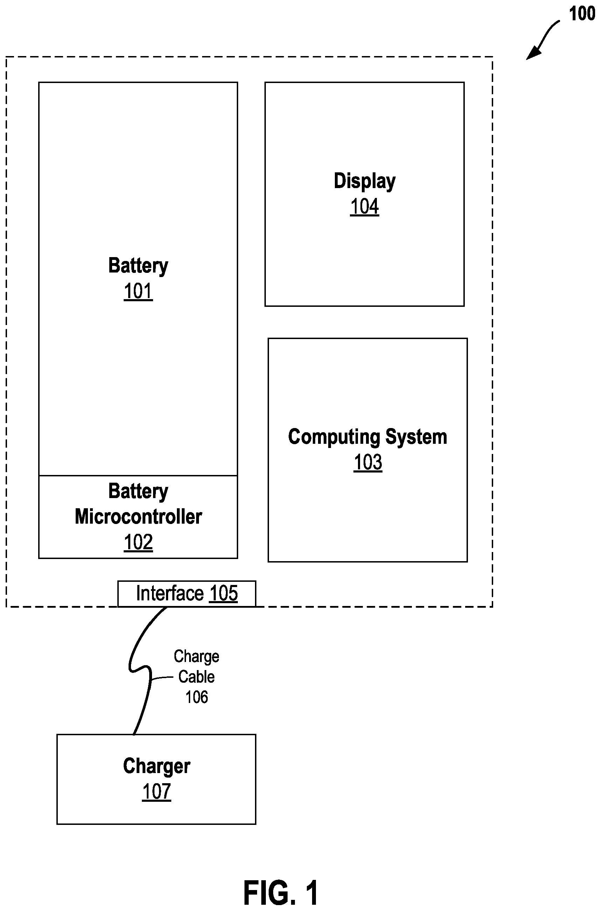

FIG. 1 illustrates a block diagram of a device 100 to provide an adaptive battery usage window, according to an embodiment. Device 100 may be any type of device with a battery such as a mobile computing device including a smartphone, tablet, UMPC (Ultra-Mobile Personal Computer), laptop computer, Ultrabook^{™} computing device, wearable devices (such as a smart watch, smart ring, smart bracelet, or smart glasses), etc. Device 100 may also be an Electrical Vehicle (EV) such as an EV sedan, truck, motorcycle, scooter, bicycle, drone, airplane, helicopter, ship, boat, etc.

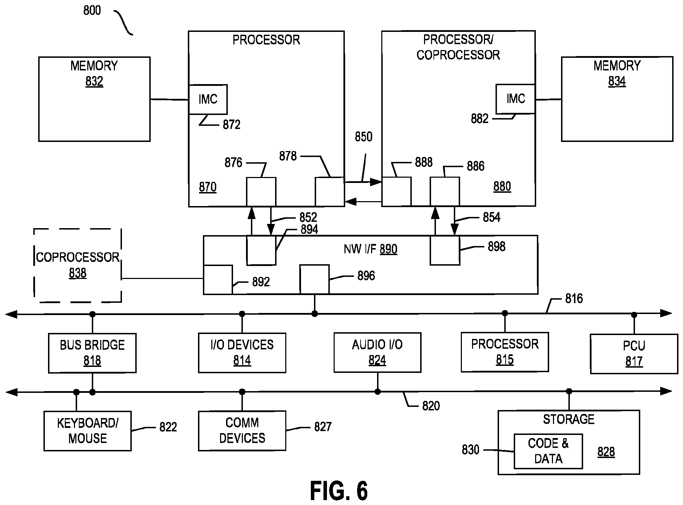

Referring to FIG. 1, device 100 includes a rechargeable battery 101, a battery microcontroller 102, computing system 103, display 104 (e.g., to display information regarding the battery such as SOC, age, charge sessions, charging speed, battery temperature, limited charging modes available, limited charge mode selected, etc.), and interface 105 for charging cable 106. Charging cable 106 is coupled to a charger 107 which is capable of providing a charge to battery 101 (including a fast charge). In some embodiments, battery 101 and battery microcontroller 102 are part of a battery unit, where battery 101 comprises a number of battery cells electrically connected together. In some embodiments, battery 101 uses Li-ion technology. In some embodiments, microcontroller 102 includes a fuel gauge and logic for an adaptive battery usage window charging. In some embodiments, computing system 103 is a system-on-chip (or "SoC") as described with reference to FIG. 6.

A memory (e.g., provided by the computing system 103 and/or a separate memory in the device 100 or coupled to the device 100 via a communication channel such as the cloud, cellular network, wireless connectivity, Internet, Internet of Things (IoT) device, etc.) may store various information/data relating to the battery 101, including limited charging mode profiles, historical data, etc. The stored data may be accessed by the battery microcontroller 102 and/or a processor (e.g., in the computing system 103) to perform analysis, machine-learning/deep-learning algorithms, etc. to control the charging of the battery 101.

Moreover, device 100 includes interface 105 which can be connected to a charging cable 106. Charging cable 106 can be a universal serial bus compliant cable or any other suitable cable. Charging cable 106 is connected to charger 107, which is capable of supplying an electrical charge.

In some embodiments, logic circuitry provided in the device 100 (such as in the microcontroller 102 and/or computing system 103) applies an adaptive battery usage window charging algorithm as discussed herein. In some embodiments, microcontroller 102, computing system 103, and/or software (e.g., executing on the microcontroller 102 and/or the computing system 103) records the battery's State-Of-Charge (SOC).

In some embodiments, microcontroller 102, computing system 103, and/or software changes the charging settings to at least one of the following-adaptive battery usage window charging, limited charging, and/or reduced charging speed. Limited charging is done to mitigate negative impacts of battery degradation due to full - charging of the battery. Reduced charging speed is done to mitigate negative impacts of battery degradation from fast charging.

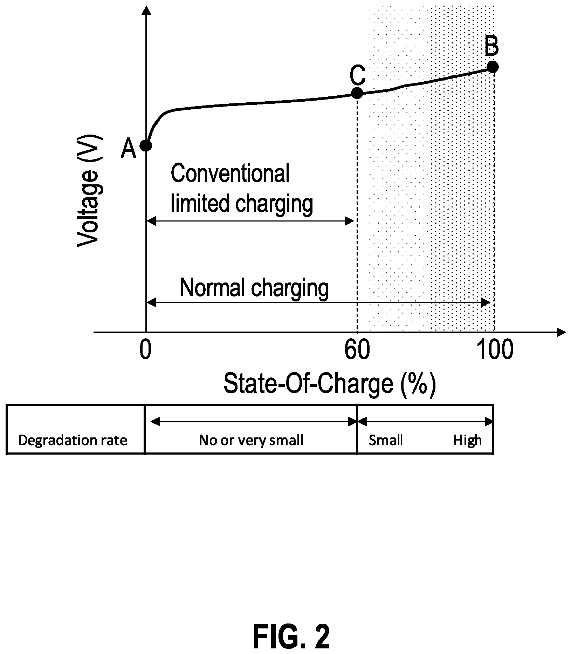

FIG. 2 illustrates an example graph of a conventional limited charging approach compared to normal charging. Li-ion battery is normally charged from point A to point B, which is equivalent to 100% charge. To extend battery longevity, today's systems may avoid high degradation regions above, e.g., 60% SOC, where degradation rate is higher when SOC is closer to 100%. For example, when the system needs 60%, system uses 60% between 0% and 60% (point A to C). When 80% is needed, system uses 80% between 0% and 80%. This means that today's battery life or charging percentage in a limited charging mode is calculated from 0% SOC.

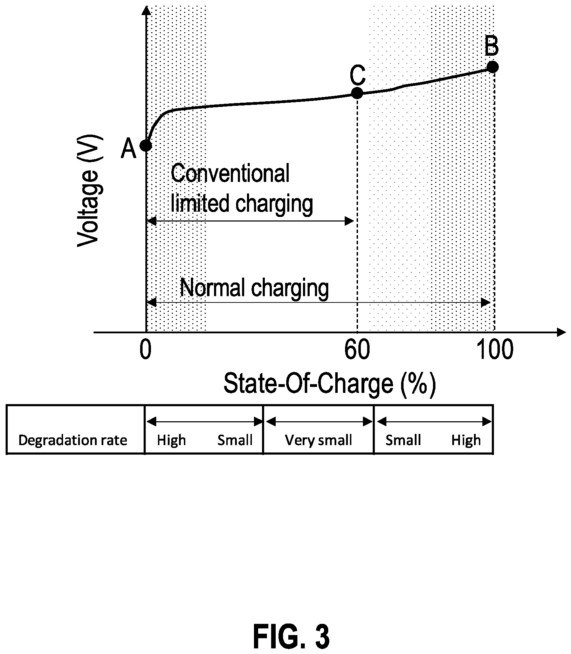

FIG. 3 illustrates a sample graph of degradation regions of next generation battery. Next generation batteries such as a Li-ion battery with Silicon (Si) anode show high degradation region in a low SOC region as well as a high SOC region, as shown in FIG. 3. This is because a Silicon anode swells/shrinks during charge/discharge (e.g., at very low SOC (e.g., below 10%) and very high SOC (e.g., above 90%)). This mechanical stress causes battery degradation in a low SOC region. Generally, Si is currently considered by the industry because Si possesses the greater gravimetric and volumetric capacity than conventional graphite anode and is also available at a very affordable cost. The conventional limited charging method overlaps with a high degradation region in low SOC and does not offer the ideal longevity extension.

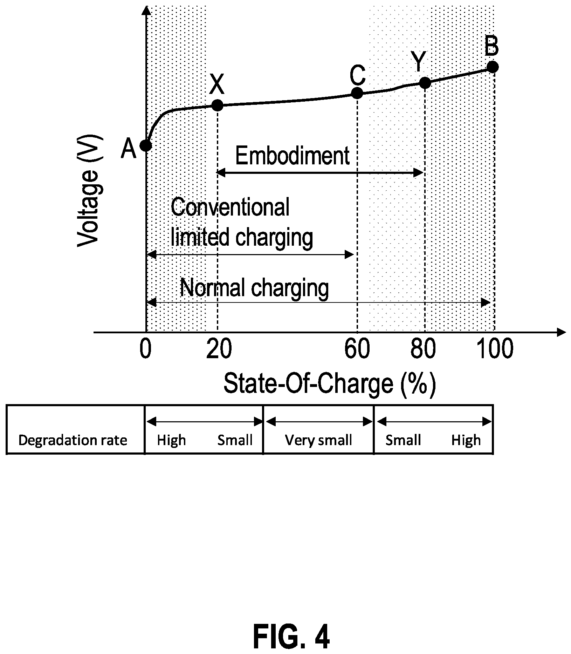

To this end, at least one embodiment optimizes a battery usage window to extend battery longevity. More particularly, FIG. 4 illustrates a graph for an adaptive battery usage window to extend battery longevity, according to an embodiment. Also, while some embodiments are discussed with reference to Si anodes, embodiments are not limited to Si anodes and one or more embodiments may be applied to any battery technology with Lithium-ion, even for future Lithium metal anode batteries.

As shown in FIG. 4, battery degradation rates are not only considered in high SOC regions but also low SOC regions. Then, in a limited charging mode, the battery usage window is adjusted to avoid high degradation-rate regions in both high SOC and low SOC and minimizes degradation rate. For example, when 60% charge is set in a limited charging mode and a battery has high degradation regions below 20% SOC and greater than 80% SOC, the charging mode charges to 80% (point Y) so that the usage window is from 20% SOC (point X) to 80% SOC (point Y). In contrast, conventional limited charging would charge the battery to 60% and battery usage window would overlap with high degradation region below 20% SOC.

In various embodiments, the upper and lower limits of the battery usage window may be determined based on battery SOC, battery voltage level, and/or charged/discharged capacity amount. Other factors that may be considered include the age of the battery (e.g., the number of charge/discharge cycles) and/or temperature.

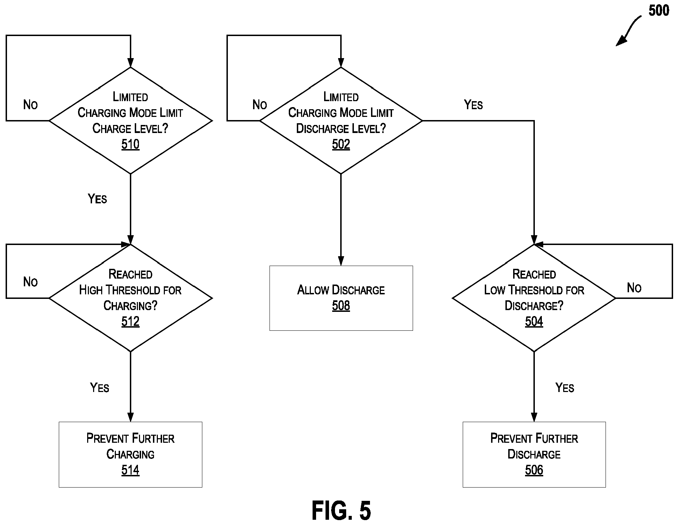

FIG. 5 illustrates a flow diagram of a method 500 to provide an adaptive battery usage window to extend battery longevity, according to an embodiment. One or more of the operations of method 500 may be performed by one or more components of the device 100 of FIG. 1 (such as the battery microcontroller 102) and/or one or more components of the system 600 of FIG. 6 (e.g., including one or more processor/cores, memory, communication devices, etc.).

In an embodiment, a plurality of limited charging modes may be available to indicate various charging limitations for a rechargeable battery, e.g., including low charging threshold level and/or high charging threshold level to implement the usage window discussed herein, e.g., with reference to FIG. 4.

Referring to FIGs. 1 to 5, at an operation 502, it is determined whether a selected limited charging mode implements a low SOC limit. If so, an operation 504 determines whether the low threshold for discharge has been reached and if it has, an operation 506 prevents further discharge in accordance with the selected limited charging criteria. If no low threshold level is selected (as determined at operation 502), an operation 508 allows discharge, e.g., to 0%. In at least one embodiment, the logic circuitry may adaptively switch between different limited charging modes.

At an operation 510, it is determined whether a threshold is set in the selected limited charging mode to limit the maximum SOC for the battery. If so, an operation 512 determines whether a high threshold level for charging has been reached and if so, further charging is prevented. In at least one embodiment, all operations of method 500 are performed by logic circuitry (such as the battery microcontroller 102 and/or a processor/core of the computing system 103).

In an embodiment, a user (locally or remotely (e.g., via an application)) can manually select which charging percentages are to be used, Alternatively, an algorithm (e.g., machine-learning/deep-learning) can automatically specify the charging percentage, e.g., based on fuel gauging and/or historical usage/charging data.

In one embodiment, a limited charging mode limits the charging amount and shows a full-charge battery indicator (e.g., full-charge capacity or full-charge battery-life/driving-range) based on the limited charging amount, e.g., even if the battery is charged to 80%.

At least one embodiment considers a plurality of degradation rates for battery SOC regions and adjusts the battery usage window that corresponds to the limited charging amount to minimize degradation rate. The algorithm used to adjust the battery usage window may reside in a local system or in a remote system. Also, the upper and lower limits of the battery usage window may be based on battery SOC, battery voltage, and/or charged/discharged amount.

Further, the target charge amount may be specified by a user, a machine-learning algorithm (e.g., that monitors battery usage patterns), an Information Technology (IT) department, etc. In some implementations, limited charging mode can be found easily. For example, Microsoft Windows^{®} 11 shows smart charging icon during a limited charging mode. "powercfg -batteryreport" command in command prompt shows the changes of battery charge capacity (e.g., from 100% to 80% charge).

Moreover, in at least one embodiment, the priority and/or the amount of avoidance in high or low SOC regions are to be determined based at least in part on degradation rates of the high or low SOC regions. For example, if 90-100% SOC would cause the most degradation, 0-10% SOC would cause the 2nd most degradation, and 80-90% SOC would cause the 3rd most degradation, an embodiment adjusts the usage window as follows: (1) when 90% charge is needed, the window is 0-90% to avoid the most degradation region; (2) when 80% charge is needed, the window is 10-90%, avoiding the 2nd most degradation region in addition; and (3) when 70% charge is needed, the window is 10-80%, avoiding the 3rd most degradation region in addition.

Additionally, some embodiments may be applied in computing systems that include one or more processors (e.g., where the one or more processors may include one or more processor cores), such as those discussed with reference to FIGs. 1 et seq., including for example a desktop computer, a workstation, a computer server, a server blade, or a mobile computing device. The mobile computing device may include a smartphone, tablet, UMPC (Ultra-Mobile Personal Computer), laptop computer, Ultrabook^{™} computing device, wearable devices (such as a smart watch, smart ring, smart bracelet, or smart glasses), etc.

### EXAMPLE COMPUTER ARCHITECTURES

Detailed below are descriptions of example computer architectures. Other system designs and configurations known in the arts for laptop, desktop, and handheld personal computers (PC)s, personal digital assistants, engineering workstations, servers, disaggregated servers, network devices, network hubs, switches, routers, embedded processors, digital signal processors (DSPs), graphics devices, video game devices, set-top boxes, micro controllers, cell phones, portable media players, hand-held devices, and various other electronic devices, are also suitable. In general, a variety of systems or electronic devices capable of incorporating a processor and/or other execution logic as disclosed herein are generally suitable.

FIG. 8 illustrates an example computing system. Multiprocessor system 800 is an interfaced system and includes a plurality of processors or cores including a first processor 870 and a second processor 880 coupled via an interface 850 such as a point-to-point (P-P) interconnect, a fabric, and/or bus. In some examples, the first processor 870 and the second processor 880 are homogeneous. In some examples, first processor 870 and the second processor 880 are heterogenous. Though the example system 800 is shown to have two processors, the system may have three or more processors, or may be a single processor system. In some examples, the computing system is a system on a chip (SoC).

Processors 870 and 880 are shown including integrated memory controller (IMC) circuitry 872 and 882, respectively. Processor 870 also includes interface circuits 876 and 878; similarly, second processor 880 includes interface circuits 886 and 888. Processors 870, 880 may exchange information via the interface 850 using interface circuits 878, 888. IMCs 872 and 882 couple the processors 870, 880 to respective memories, namely a memory 832 and a memory 834, which may be portions of main memory locally attached to the respective processors.

Processors 870, 880 may each exchange information with a network interface (NW I/F) 890 via individual interfaces 852, 854 using interface circuits 876, 894, 886, 898. The network interface 890 (e.g., one or more of an interconnect, bus, and/or fabric, and in some examples is a chipset) may optionally exchange information with a coprocessor 838 via an interface circuit 892. In some examples, the coprocessor 838 is a special-purpose processor, such as, for example, a high-throughput processor, a network or communication processor, compression engine, graphics processor, general purpose graphics processing unit (GPGPU), neural-network processing unit (NPU), embedded processor, or the like.

A shared cache (not shown) may be included in either processor 870, 880 or outside of both processors, yet connected with the processors via an interface such as P-P interconnect, such that either or both processors' local cache information may be stored in the shared cache if a processor is placed into a low power mode.

Network interface 890 may be coupled to a first interface 816 via interface circuit 896. In some examples, first interface 816 may be an interface such as a Peripheral Component Interconnect (PCI) interconnect, a PCI Express interconnect or another I/O interconnect. In some examples, first interface 816 is coupled to a power control unit (PCU) 8 17, which may include circuitry, software, and/or firmware to perform power management operations with regard to the processors 870, 880 and/or co-processor 838. PCU 817 provides control information to a voltage regulator (not shown) to cause the voltage regulator to generate the appropriate regulated voltage. PCU 817 also provides control information to control the operating voltage generated. In various examples, PCU 817 may include a variety of power management logic units (circuitry) to perform hardware-based power management. Such power management may be wholly processor controlled (e.g., by various processor hardware, and which may be triggered by workload and/or power, thermal or other processor constraints) and/or the power management may be performed responsive to external sources (such as a platform or power management source or system software).

PCU 817 is illustrated as being present as logic separate from the processor 870 and/or processor 880. In other cases, PCU 817 may execute on a given one or more of cores (not shown) of processor 870 or 880. In some cases, PCU 817 may be implemented as a microcontroller (dedicated or general-purpose) or other control logic configured to execute its own dedicated power management code, sometimes referred to as P-code. In yet other examples, power management operations to be performed by PCU 817 may be implemented externally to a processor, such as by way of a separate power management integrated circuit (PMIC) or another component external to the processor. In yet other examples, power management operations to be performed by PCU 817 may be implemented within BIOS or other system software.

Various I/O devices 814 may be coupled to first interface 816, along with a bus bridge 818 which couples first interface 816 to a second interface 820. In some examples, one or more additional processor(s) 815, such as coprocessors, high throughput many integrated core (MIC) processors, GPGPUs, accelerators (such as graphics accelerators or digital signal processing (DSP) units), field programmable gate arrays (FPGAs), or any other processor, are coupled to first interface 816. In some examples, second interface 820 may be a low pin count (LPC) interface. Various devices may be coupled to second interface 820 including, for example, a keyboard and/or mouse 822, communication devices 827 and storage circuitry 828. Storage circuitry 828 may be one or more non-transitory machine-readable storage media as described below, such as a disk drive or other mass storage device which may include instructions/code and data 830 and may implement the storage for one or more instructions in some examples. Further, an audio I/O 824 may be coupled to second interface 820. Note that other architectures than the point-to-point architecture described above are possible. For example, instead of the point-to-point architecture, a system such as multiprocessor system 800 may implement a multi-drop interface or other such architecture. EXAMPLE CORE ARCHITECTURES, PROCESSORS, AND COMPUTER ARCHITECTURES.

Processor cores may be implemented in different ways, for different purposes, and in different processors. For instance, implementations of such cores may include: 1) a general purpose in-order core intended for general-purpose computing; 2) a high-performance general purpose out-of-order core intended for general-purpose computing; 3) a special purpose core intended primarily for graphics and/or scientific (throughput) computing. Implementations of different processors may include: 1) a CPU including one or more general purpose in-order cores intended for general-purpose computing and/or one or more general purpose out-of-order cores intended for general-purpose computing; and 2) a coprocessor including one or more special purpose cores intended primarily for graphics and/or scientific (throughput) computing. Such different processors lead to different computer system architectures, which may include: 1) the coprocessor on a separate chip from the CPU; 2) the coprocessor on a separate die in the same package as a CPU; 3) the coprocessor on the same die as a CPU (in which case, such a coprocessor is sometimes referred to as special purpose logic, such as integrated graphics and/or scientific (throughput) logic, or as special purpose cores); and 4) a system on a chip (SoC) that may be included on the same die as the described CPU (sometimes referred to as the application core(s) or application processor(s)), the above described coprocessor, and additional functionality. Example core architectures are described next, followed by descriptions of example processors and computer architectures.

FIG. 9 illustrates a block diagram of an example processor and/or SoC 900 that may have one or more cores and an integrated memory controller. The solid lined boxes illustrate a processor 900 with a single core 902(A), system agent unit circuitry 910, and a set of one or more interface controller unit(s) circuitry 916, while the optional addition of the dashed lined boxes illustrates an alternative processor 900 with multiple cores 902(A)-(N), a set of one or more integrated memory controller unit(s) circuitry 914 in the system agent unit circuitry 910, and special purpose logic 908, as well as a set of one or more interface controller units circuitry 916. Note that the processor 900 may be one of the processors 870 or 880, or co-processor 838 or 815 of FIG. 8.

Thus, different implementations of the processor 900 may include: 1) a CPU with the special purpose logic 908 being integrated graphics and/or scientific (throughput) logic (which may include one or more cores, not shown), and the cores 902(A)-(N) being one or more general purpose cores (e.g., general purpose in-order cores, general purpose out-of-order cores, or a combination of the two); 2) a coprocessor with the cores 902(A)-(N) being a large number of special purpose cores intended primarily for graphics and/or scientific (throughput); and 3) a coprocessor with the cores 902(A)-(N) being a large number of general purpose in-order cores. Thus, the processor 900 may be a general-purpose processor, coprocessor or special-purpose processor, such as, for example, a network or communication processor, compression engine, graphics processor, GPGPU (general purpose graphics processing unit), a high throughput many integrated core (MIC) coprocessor (including 30 or more cores), embedded processor, or the like. The processor may be implemented on one or more chips. The processor 900 may be a part of and/or may be implemented on one or more substrates using any of a number of process technologies, such as, for example, complementary metal oxide semiconductor (CMOS), bipolar CMOS (BiCMOS), P-type metal oxide semiconductor (PMOS), or N-type metal oxide semiconductor (NMOS).

A memory hierarchy includes one or more levels of cache unit(s) circuitry 904(A)-(N) within the cores 902(A)-(N), a set of one or more shared cache unit(s) circuitry 906, and external memory (not shown) coupled to the set of integrated memory controller unit(s) circuitry 914. The set of one or more shared cache unit(s) circuitry 906 may include one or more mid-level caches, such as level 2 (L2), level 3 (L3), level 4 (L4), or other levels of cache, such as a last level cache (LLC), and/or combinations thereof. While in some examples interface network circuitry 912 (e.g., a ring interconnect) interfaces the special purpose logic 908 (e.g., integrated graphics logic), the set of shared cache unit(s) circuitry 906, and the system agent unit circuitry 910, alternative examples use any number of well-known techniques for interfacing such units. In some examples, coherency is maintained between one or more of the shared cache unit(s) circuitry 906 and cores 902(A)-(N). In some examples, interface controller units circuitry 916 couple the cores 902 to one or more other devices 918 such as one or more I/O devices, storage, one or more communication devices (e.g., wireless networking, wired networking, etc.), etc.

In some examples, one or more of the cores 902(A)-(N) are capable of multi-threading. The system agent unit circuitry 910 includes those components coordinating and operating cores 902(A)-(N). The system agent unit circuitry 910 may include, for example, power control unit (PCU) circuitry and/or display unit circuitry (not shown). The PCU may be or may include logic and components needed for regulating the power state of the cores 902(A)-(N) and/or the special purpose logic 908 (e.g., integrated graphics logic). The display unit circuitry is for driving one or more externally connected displays.

The cores 902(A)-(N) may be homogenous in terms of instruction set architecture (ISA). Alternatively, the cores 902(A)-(N) may be heterogeneous in terms of ISA; that is, a subset of the cores 902(A)-(N) may be capable of executing an ISA, while other cores may be capable of executing only a subset of that ISA or another ISA.

In this description, numerous specific details are set forth to provide a more thorough understanding. However, it will be apparent to one of skill in the art that the embodiments described herein may be practiced without one or more of these specific details. In other instances, well-known features have not been described to avoid obscuring the details of the present embodiments.

The following examples pertain to further embodiments. Example 1 includes an apparatus comprising: a memory to store data associated with a rechargeable battery; and logic circuitry to control a State Of Charge (SOC) for the rechargeable battery based on a plurality of limited charging modes, the logic circuitry to prevent the rechargeable battery from discharging below a low threshold level during a first limited charging mode of the plurality of charging modes, and the logic circuitry to allow the rechargeable battery to discharge below the low threshold level during a second limited charging mode of the plurality of charging modes, wherein the logic circuitry is to adaptively adjust a usage window of the rechargeable battery based at least in part on the first limited charging mode and the second limited charging mode.

Example 2 includes the apparatus of example 1, wherein the logic circuitry is to adaptively switch between the first limited charging mode and the second limited charging mode based at least in part on a state of a selection signal. Example 3 includes the apparatus of example 2, wherein the selection signal is to be generated in response to at least one of a user input, a remote system input, an information technology department input, or machine-learning algorithm input. Example 4 includes the apparatus of example 3, wherein the machine-learning algorithm input is to be generated based at least in part on monitoring of usage patterns for the rechargeable battery. Example 5 includes the apparatus of example 1, wherein the logic circuity is to prevent the rechargeable battery from charging above a high threshold level during the first limited charging mode or the second limited charging mode. Example 6 includes the apparatus of example 1, wherein the stored data comprises at least one of data associated with the plurality of limited charging modes, historical data, or data generated by a machine-learning algorithm. Example 7 includes the apparatus of example 6, wherein the historical data comprises data corresponding to at least one of operation, usage, timestamp, state of charge, charging, or discharging of the rechargeable battery.

Example 8 includes the apparatus of example 1, wherein the logic circuity is to prevent the rechargeable battery from charging above a high threshold level, wherein the low threshold level and the high threshold level are to be determined based at least in part on at least one of a SOC of the rechargeable battery, a voltage level of the rechargeable battery, or the age of the rechargeable battery. Example 9 includes the apparatus of example 8, wherein the age of the rechargeable battery is to be determined based on at least one of a number of charge/discharge cycles performed by the rechargeable battery, a state of health of the rechargeable battery, or full charge capacity of the rechargeable battery. Example 10 includes the apparatus of example 1, wherein the logic circuity is to prevent the rechargeable battery from charging above a high threshold level, wherein a battery indicator is to indicate a charge level compared to the capacity of the adjusted usage window for the rechargeable battery. Example 11 includes the apparatus of example 1, wherein a priority or an amount of avoidance in high or low SOC regions are to be determined based at least in part on degradation rates of the high or low SOC regions.

Example 12 includes one or more non-transitory computer-readable media comprising one or more instructions that when executed on a processor configure the processor to perform one or more operations to: store data associated with a rechargeable battery; and control a State Of Charge (SOC) for the rechargeable battery based on a plurality of limited charging modes, wherein the rechargeable battery is to be prevented from discharging below a low threshold level during a first limited charging mode of the plurality of charging modes, wherein the rechargeable battery is to be allowed to discharge below the low threshold level during a second limited charging mode of the plurality of charging modes, wherein the processor is to adaptively adjust a usage window of the rechargeable battery based at least in part on the first limited charging mode and the second limited charging mode. Example 13 includes the one or more computer-readable media of example 12, further comprising one or more instructions that when executed on the processor configure the processor to perform one or more operations to cause adaptive switching between the first limited charging mode and the second limited charging mode based at least in part on a state of a selection signal.

Example 14 includes the one or more computer-readable media of example 13, further comprising one or more instructions that when executed on the processor configure the processor to perform one or more operations to cause generation of the selection signal in response to at least one of a user input, a remote system input, an information technology department input, or machine-learning algorithm input. Example 15 includes the one or more computer-readable media of example 14, further comprising one or more instructions that when executed on the processor configure the processor to perform one or more operations to cause the machine-learning algorithm input to be generated based at least in part on monitoring of usage patterns for the rechargeable battery.

Example 16 includes the one or more computer-readable media of example 12, further comprising one or more instructions that when executed on the processor configure the processor to perform one or more operations to prevent the rechargeable battery from charging above a high threshold level during the first limited charging mode or the second limited charging mode. Example 17 includes the one or more computer-readable media of example 12, wherein the stored data comprises at least one of data associated with the plurality of limited charging modes, historical data, or data generated by a machine-learning algorithm. Example 18 includes the one or more computer-readable media of example 17, wherein the historical data comprises data corresponding to at least one of operation, usage, timestamp, state of charge, charging, or discharging of the rechargeable battery.

Example 19 includes the one or more computer-readable media of example 12, further comprising one or more instructions that when executed on the processor configure the processor to perform one or more operations to prevent the rechargeable battery from charging above a high threshold level, wherein the low threshold level and the high threshold level are to be determined based at least in part on at least one of a SOC of the rechargeable battery, a voltage level of the rechargeable battery, or the age of the rechargeable battery. Example 20 includes the one or more computer-readable media of example 12, further comprising one or more instructions that when executed on the processor configure the processor to perform one or more operations to determine the age of the rechargeable battery based on at least one of a number of charge/discharge cycles performed by the rechargeable battery, a state of health of the rechargeable battery, or full charge capacity of the rechargeable battery.

Example 21 includes an apparatus comprising means to perform a method as set forth in any preceding example. Example 22 comprises machine-readable storage including machine-readable instructions, when executed, to implement a method or realize an apparatus as set forth in any preceding example.

In various embodiments, one or more operations discussed with reference to FIGs. 1 et seq. may be performed by one or more components (interchangeably referred to herein as "logic") discussed with reference to any of the figures.

In some embodiments, the operations discussed herein, e.g., with reference to FIGs. 1 et seq., may be implemented as hardware (e.g., logic circuitry), software, firmware, or combinations thereof, which may be provided as a computer program product, e.g., including one or more tangible (e.g., non-transitory) machine-readable or computer-readable media having stored thereon instructions (or software procedures) used to program a computer to perform a process discussed herein. The machine-readable medium may include a storage device such as those discussed with respect to the figures.

Further, while various embodiments described herein use the term System-on-a-Chip or System-on-Chip ("SoC" or "SOC") to describe a device or system having a processor and associated circuitry (e.g., Input/Output ("I/O") circuitry, power delivery circuitry, memory circuitry, etc.) integrated monolithically into a single Integrated Circuit ("IC") die, or chip, the present disclosure is not limited in that respect. For example, in various embodiments of the present disclosure, a device or system can have one or more processors (e.g., one or more processor cores) and associated circuitry (e.g., Input/Output ("I/O") circuitry, power delivery circuitry, etc.) arranged in a disaggregated collection of discrete dies, tiles and/or chiplets (e.g., one or more discrete processor core die arranged adjacent to one or more other die such as memory die, I/O die, etc.). In such disaggregated devices and systems, the various dies, tiles and/or chiplets can be physically and/or electrically coupled together by a package structure including, for example, various packaging substrates, interposers, active interposers, photonic interposers, interconnect bridges, and the like. The disaggregated collection of discrete dies, tiles, and/or chiplets can also be part of a System-on-Package ("SoP").

Additionally, such computer-readable media may be downloaded as a computer program product, wherein the program may be transferred from a remote computer (e.g., a server) to a requesting computer (e.g., a client) by way of data signals provided in a carrier wave or other propagation medium via a communication link (e.g., a bus, a modem, or a network connection).

Reference in the specification to "one embodiment" or "an embodiment" means that a particular feature, structure, and/or characteristic described in connection with the embodiment may be included in at least an implementation. The appearances of the phrase "in one embodiment" in various places in the specification may or may not be all referring to the same embodiment.

Also, in the description and claims, the terms "coupled" and "connected," along with their derivatives, may be used. In some embodiments, "connected" may be used to indicate that two or more elements are in direct physical or electrical contact with each other. "Coupled" may mean that two or more elements are in direct physical or electrical contact. However, "coupled" may also mean that two or more elements may not be in direct contact with each other, but may still cooperate or interact with each other.

Thus, although embodiments have been described in language specific to structural features and/or methodological acts, it is to be understood that claimed subject matter may not be limited to the specific features or acts described. Rather, the specific features and acts are disclosed as sample forms of implementing the claimed subject matter.

## Claims

1. An apparatus comprising:
a memory to store data associated with a rechargeable battery; and
logic circuitry to control a State Of Charge (SOC) for the rechargeable battery based on a plurality of limited charging modes,
the logic circuitry to prevent the rechargeable battery from discharging below a low threshold level during a first limited charging mode of the plurality of charging modes, and
the logic circuitry to allow the rechargeable battery to discharge below the low threshold level during a second limited charging mode of the plurality of charging modes,
wherein the logic circuitry is to adaptively adjust a usage window of the rechargeable battery based at least in part on the first limited charging mode and the second limited charging mode.

2. The apparatus of claim 1, wherein the logic circuitry is to adaptively switch between the first limited charging mode and the second limited charging mode based at least in part on a state of a selection signal.

3. The apparatus of any one of claims 1 to 2, wherein the selection signal is to be generated in response to at least one of a user input, a remote system input, an information technology department input, or machine-learning algorithm input.

4. The apparatus of any one of claims 1 to 3, wherein the machine-learning algorithm input is to be generated based at least in part on monitoring of usage patterns for the rechargeable battery.

5. The apparatus of any one of claims 1 to 4, wherein the logic circuity is to prevent the rechargeable battery from charging above a high threshold level during the first limited charging mode or the second limited charging mode.

6. The apparatus of any one of claims 1 to 5, wherein the stored data comprises at least one of data associated with the plurality of limited charging modes, historical data, or data generated by a machine-learning algorithm.

7. The apparatus of any one of claims 1 to 6, wherein the historical data comprises data corresponding to at least one of operation, usage, timestamp, state of charge, charging, or discharging of the rechargeable battery.

8. The apparatus of any one of claims 1 to 7, wherein the logic circuity is to prevent the rechargeable battery from charging above a high threshold level, wherein the low threshold level and the high threshold level are to be determined based at least in part on at least one of a SOC of the rechargeable battery, a voltage level of the rechargeable battery, or the age of the rechargeable battery.

9. The apparatus of any one of claims 1 to 8, wherein the age of the rechargeable battery is to be determined based on at least one of a number of charge/discharge cycles performed by the rechargeable battery, a state of health of the rechargeable battery, or full charge capacity of the rechargeable battery.

10. The apparatus of any one of claims 1 to 9, wherein the logic circuity is to prevent the rechargeable battery from charging above a high threshold level, wherein a battery indicator is to indicate a charge level compared to the capacity of the adjusted usage window for the rechargeable battery.

11. The apparatus of any one of claims 1 to 10, wherein a priority or an amount of avoidance in high or low SOC regions are to be determined based at least in part on degradation rates of the high or low SOC regions.

12. An apparatus comprising means to perform a method as set forth in any preceding claim.

13. Machine-readable storage including machine-readable instructions, when executed, to implement a method or realize an apparatus as set forth in any preceding claim.
